# EUROPEAN PATENT SPECIFICATION

(11) **EP 3 081 610 B1**
(45) Date of publication and mention of the grant of the patent: **28.04.2021**
(21) Application number: 15835176.7
(22) Date of filing: 10.08.2015
(51) Int. Cl.: C09J 7/10, C09J 9/02, C09J 183/04, H01L 21/52

(54) **CONDUCTIVE ADHESIVE FILM**
LEITFÄHIGE HAFTFOLIE
FILM ADHÉSIF CONDUCTEUR

(30) Priority: 29.08.2014 JP 2014176359
(43) Date of publication of application: 19.10.2016
(73) Proprietor: Furukawa Electric Co., Ltd., Chiyoda-ku Tokyo 100-8322 (JP)
(72) Inventor: MIHARA, Naoaki, Tokyo 100-8322 (JP); KIRIKAE, Noriyuki, Tokyo 100-8322 (JP); SUGIYAMA, Jirou, Tokyo 100-8322 (JP); AOYAMA, Masami, Tokyo 100-8322 (JP)
(74) Representative: Hermann, Felix
(86) International application number: PCT/JP2015/072709
(87) International publication number: WO 2016/031551

(56) References cited:
- EP-A1- 1 763 040
- WO-A1-2007/049548
- WO-A1-2009/022574
- JP-A- H10 208 919
- JP-A- 2004 533 705
- JP-A- 2008 303 253
- JP-A- 2009 227 716
- JP-A- 2009 242 508
- JP-A- 2012 169 573
- US-A1- 2014 120 356
- DATABASE WPI Week 200972 Thomson Scientific, London, GB; AN 2009-Q32326 XP002771853, & JP 2009 242508 A (ASAHI KASEI E-MATERIALS CORP) 22 October 2009 (2009-10-22)

## Description

### TECHNICAL FIELD

The present invention relates to a lead-free adhesive film that shows conductivity, which can be used for packaging semiconductor device and heat radiation member etc., a dicing die bonding film obtained by combining said film with a dicing tape, and a method for processing semiconductor wafer using the same.

### Background Art

The use of solder, which contains lead, has widely been known as a method for packaging semiconductor device on lead frames etc. However, in recent years, due to heightened awareness on environmental issues, movement to regulate the use of lead is spreading. Under such circumstances, lead-free solder pastes such as sintered silver, Sn-Bi type, Cu-Sn type, Cu-Ag-Sn type are attracting attention. In particular, sintered silver and Cu-Sn type solder, which can be sintered at a relatively low temperature, while showing high melting temperature after being sintered, is extremely useful, since it can achieve both easy packaging and high heat resistance.

However, sintered silver are very costly, and require sintering at a high temperature of 300°C or above, thereby being likely to cause damage on other materials surrounding the semiconductor device. Further, because lead-free solders are poor in wet-spreading on semiconductor rear-side electrodes, in order to obtain sufficient adhesive strength, one had to use plenty on the semiconductor chip to be installed. Therefore, there was a problem in that balancing overflow and bond strength was difficult.

To deal with such problems, adhesive tapes containing conductive particles in epoxy resins or acrylic resins have been proposed (Patent Documents 1 to 3). By dicing a wafer along with the adhesive tape after fixing such adhesive tape on the semiconductor wafer, problems that arise when installing semiconductor chips can be solved.

However, there are issues concerning the heat resistance of such resins at environments of, for example, 250°C or higher, and when combined with devices that use wide-gap semiconductors such as Si-C, it was difficult to make the most of the excellent heat resistance of the device. While enlarging the crosslinking density of the epoxy or acrylic resin improves heat resistance, the hardness of the cured resin becomes excessive, thereby leading to a lack of stress relaxation property and causing problems of chips and lead frames curving.

For such problems regarding the balance of heat resistance and stress relaxation, the use of silicone resin, which is flexible while showing excellent heat resistance, has been proposed.

However, when such silicone resins are used as binders, the diffusion of metals during sintering becomes poor. In particular, because sintering between metal particles is inhibited when combined with lead-free solders that form intermetallic compounds, there was a problem in that obtaining sufficient conductivity for use in, for example, rear-side electrodes of high voltage or high frequency power semiconductors was difficult.

### RELATED ART

### Patent and non-patent Documents

Patent Document 1: JP-A-2004-160508
Patent Document 2: WO2011/083824
Patent Document 3: US2014/0120356 A1
Patent Document 4: JP-A-2013-221082
Patent Document 5: WO2010/103998

Patent document 3 US 2014/120356 A1 discloses a composition and process for formation of a conductive bonding film, combining adhesive bonding sheet technologies (e.g. die attach films, or DAFs) with the electrical and thermal conductivity performance of transient liquid phase sintered paste compositions.

Furthermore, EP 1 763 040 A1 reveals an interface material for electronic devices comprising at least one resin material and at least one solder material comprising indium, silver, copper, aluminum, tin, bismuth, gallium and alloys thereof, silver-coated copper, silver-coated aluminum.

Non-patent document Database WPI, Week 200972, Thomson Scientific, London, GB; AN 2009-Q32326 & JP 2009 242508 A (ASAHI KASEI E-MATERIALS CORP) 22 October 2009 (2009-10-22)) discloses an adhesive agent for adhering a semiconductor element on support base materials, wherein said agent comprises an epoxy modified silicone resin, an additional silicone adhesive and metallic particles.

Further, WO 2007/049548 A1 discloses electroconductive bonding sheets comprising adhesive and electroconductive metallic particles.

### SUMMARY

The present invention was made in order to solve the above-described problems, and provides a lead-free adhesive film that shows excellent heat resistance while showing excellent stress relaxation property, which further shows high conductivity that enables application to rear-side electrode for power semiconductors without the use of expensive precious metals such as silver, which also shows sufficient adhesive strength without protruding from the device, and a method for processing semiconductors using the same.

That is, the present invention is related to a conductive lead-free adhesive film, which comprises two or more types of metal particles including at least Cu, and a polymer that has a polydimethylsiloxane structure, wherein at least part of the polymer that has a polydimethylsiloxane structure contains -COOH, -CRₓ(OH)_{y}, or -NR₂ as functional group (where R is selected form H, alkyl, or aryl group, and x+y=3), and wherein the metal particles are capable of forming an intermetallic compound, a dicing die bonding film, which comprises the conductive adhesive film and a dicing tape, and further, a method for processing semiconductor using the same.

Further, it is preferable that the metal particles contain a component with a melting point of 250°C or lower, and are capable of forming an intermetallic compound.

Further, in order to facilitate intermetallic compound reaction, it is preferable that the conductive adhesive tape contains at least one type of flux component selected from alcohol, ketone, carboxylic acid, or amine, wherein the flux component is in a state of phase separation with the polymer that has a polydimethylsiloxane structure.

Furthermore, it is preferable that at least part of the polymer that has a polydimethylsiloxane structure contains a double bond.

Furthermore, it is preferable that the amount of the metal particle based on the entire film is 55 volume% or more and that the amount of the polymer that has a polydimethylsiloxane structure is 5 volume% or more.

Further, it is preferable that the conductive adhesive film comprises a radical generator with a one-hour half-life temperature of 200°C or higher.

### Effect of the Invention

By dicing after adhering to a semiconductor wafer, the above-described adhesive film of the present invention allows semiconductor chips to be packaged on a lead frame, using proper quantities of the adhesive film in a state of lamination on the rear-side electrode.

Preferably, it contains a metal component with a melting point of 250°C or lower and can be sintered at a temperature of 250°C or lower, contains Cu, and is capable of forming intermetallic compounds.

Further, because the binder resin is of a silicone-type, it shows high heat resistance up to a temperature of 300°C after sintering.

Furthermore, by combining a flux component that is in a state of phase separation with the silicone component, a silicone component modified by the functional group having flux function, a radical-type catalyst that accelerates the curing reaction of the silicone at a temperature of 200°C or higher, or a combination there of, the intermetallic reaction proceeds smoothly, thereby enabling high conductivity.

Further, by including Cu, the film can be provided at a lower price than, for example, sintered silver, and since it does not include lead, environmental burden becomes low, too.

The adhesive film of the present invention is especially suitable for adhering the rear-side electrode of a high-voltage, high-frequency power semiconductor to a lead frame etc., or for adhering a lead frame packaged with power semiconductors etc. to a heat dissipation member, and in particular, for packaging wide-gap semiconductor device, which is expected to operate at high temperature.

### BRIEF DESCRIPTION OF DRAWINGS

[FIG. 1] FIG. 1 shows an adhesive film with dicing tape that uses the adhesive agent of the present invention.
[FIG. 2] FIG. 2 is a sectional scheme of an embodiment of the adhesive film with dicing tape that differs from FIG. 1.

### DESCRIPTION OF SOME EMBODIMENTS

The present invention comprises at least a metal particle and a silicone-type resin that serves as a binder.

### (Metal Particles)

The metal particle contains at least Cu. The form of the Cu particle is not particularly limited, but may be, for example, spherical or flake-shaped, and preferably has a BET diameter of 0.01 to 30 µm, or more preferably, is a spherical particle with a BET diameter of 0.1 to 10 µm. The Cu particle preferably has some form of coating performed to prevent oxidation of the surface. As such coating, Au, Ag, organic acid, alcohol, thiol, alkylamine, silane coupling agent, titanium complex, silicone resin etc. may be used, but from the view point of price and coatability, organic acids, alcohols, thiol, and alkylamines are particularly favorable.

The metal particle also contains metal components other than Cu, with the limitation that the two ore more types of metal particles including at least Cu are capable of forming an intermetallic compound. Such metal component may be any metal other than lead, without further limitation, and may be Au, Ag, Pt, Ti, Al, Ni, Fe, Co, Mo, Sn, Zn, Pd, Ga, Ge, In, Sb, Bi, metallic silicon, boron, and alloys thereof or combinations thereof. However, by selecting a component with a melting point of 250°C or lower as at least part of it, it becomes favorable in that its sintering temperature can be lowered.

As such low-melting point metal, Sn, Ga, In, Sn-Bi alloy, Sn-Zn alloy, Sn-Ag alloy, Sn-Au alloy, Sn-Mg alloy, In-Sn alloy, Ga-Sn alloy, Ga-In-Sn alloy etc., and combinations thereof may be used.

In order to attain both, low-temperature workability before sintering and heat resistance after sintering, the metal particle is preferably Sn, which forms intermetallic compounds with Cu, or an alloy of Sn and another metal.

Further, the metal particle is preferably a combination containing Cu and a transition metal (Ag, Ni, Fe, Zn, Bi) and Sn, which is capable of forming an intermetallic compound. Among these, Sn-Bi alloy and Sn-Zn alloy are favorable because they are able to lower the melting point to below 200°C.

Since low volume resistivity can be obtained by sintering, the amount of the metal particle is preferably 55 volume% or more, based on the entire film, and more preferably, 60 volume% or more.

### (Silicone Resin Binder Containing Polymer with a Polydimethylsiloxane Structure)

The silicone resin that serves as a binder comprises at least a polymer that has a polydimethylsiloxane structure. The polydimethylsiloxane structure adds relaxation ability to the adhesive film, thereby suppressing curvature of the lead frame and semiconductor chip.

The polymer that has a polydimethylsiloxane structure is preferably crosslinked or crosslinkable from the view point of heat resistance. On the other hand, it is preferable that it is not crosslinked or crosslinked very lightly prior to sintering, so as not to inhibit metal diffusion for the formation of intermetallic compounds. As a polymer that contains crosslinkable polydimethylsiloxane structure, those containing hydrolyzable siloxane and those containing C=C double bond are preferable. However, form the view point of suppressing out gas components, those containing C=C double bonds, in which crosslinking proceeds through addition reaction, are more preferable. As such polymer, vinyl-modified or aryl-modified polydimethylsiloxane can be listed.

Furthermore, from the view point of adding flux function, it is necessary that at least part of the polymer that has a polydimethylsiloxane structure contains -COOH, -CRₓ(OH)_{y}, or -NR₂ as a functional group (where R is selected from H, alkyl, or aryl group, and x+y=3).

In particular, from the view point of easy film-forming of the adhesive, a both terminal vinyl-modified polydimethylsiloxane with a weight-average molecular weight of 10,000 or more is preferable, and more preferably, it may be a both terminal vinyl-modified polydimethylsiloxane with a weight-average molecular weight of 100,000 or more.

As the curing agent of the polydimethylsiloxane, a hydrogensiloxane compound that contains Si-H bond is favorable. Such as hydrogensiloxane compound, a polyhydrogen-modified polydimethylsiloxane, wherein part of the methyl group in the polydimethylsiloxane is substituted by a hydrogen is preferable, from the view point of its stability and low-pollution property.

In addition to the above, silicone resins containing many vinyl groups in the molecule may be added to control hardness and tack, and silane coupling agents and other additives may be added to enhance adhesiveness and dispersion of metal particles.

In the adhesive film of the present invention, it is preferable that the above-described components are provided in a crosslinkable state or in a crosslinked state. However, it is more preferable that parts of the components are provided crosslinked, while some unreacted C=C double bonds remain, making it possible for the crosslinking to proceed by heating.

In order to avoid compromising sinterability and conductivity after sintering, the amount of the polymer that has a polydimethylsiloxane structure is preferably 5 volume% or more based on the entire film, and more preferably, is 20 volume% or more, and even more preferably, is 25 volume% or more.

### (Radical Generator)

As a catalyst that accelerates hardening reaction, noble metal complexes such as platinum complex, and radical-type catalysts such as organic peroxides, diazo compounds, α acyloin, aromatic ketone, 2,3-diaryl-2,3-dimethylbutane etc., may be listed, but radical initiators, which are less likely to be affected by tin, and for which the reaction temperature can be easily controlled, is preferable. Among such radical initiators, those of thermal fission-type, with a one-hour half-life temperature of 200°C or higher are especially preferable, since they suppress the inhibition of intermetallic reaction due to the crosslinking reaction proceeding too quickly, while sufficiently sintering at a temperature of 250°C or lower, making it easy to obtain low volume resistivity. Those with a one-hour half-life temperature of 230°C or more to 260°C or lower are even more preferable.

As such radical initiators, for example, 2,3-diaryl-2,3-dimethylbutane etc. may be listed. These radical initiators may also be combined with noble metal catalysts.

The amount of such radical generators are preferably 0.1 percent by mass or more, based on the entire film.

### (Flux)

In order to accelerate intermetallic reaction, it is preferable to add flux.

As flux, any compound may be used, as long as it does not inhibit the hardening reaction of the curable resin and other curable resins. For example, alcohols, carboxylic acids, inorganic acids, alkanolamines, phenols, rosins, chloride compounds and their salts, halide compounds and their salts, may be listed, but alcohols, aldehydes, ketones, carboxylic acids, and amines are preferable.

The flux may be of one type or may be used as a combination of 2 or more types.

In a specific embodiment, the flux is composed of carboxylic acid and a salt of a tertiary amine or mixture thereof, and may be of potentiality.

As the aforementioned alcohol, for example, ethylene glycol, diethylene glycol, triethylene glycol, propylene glycol, octene glycol, polyethylene glycol, glycerin, propanediol, and mixtures thereof may be listed.

A the aforementioned carboxylic acid, for example, acrylic acid, m ethacrylic acid, maleic acid, fumaric acid, valeric acid, hexanoic acid, heptanoic acid, 2-ethylhexanoic acid, octanoic acid, 2-methyl heptanoic acid, 4-methyl octan oic acid, nonanoic acid, decanoic acid, neodecanoic acid, dodecanoic acid, tetrade canoic acid, lauric acid, myristic acid, palmitic acid, stearic acid, oleic acid, lino leic acid, linolenic acid, lactic acid, malic acid, citric acid, benzoic acid, phthali c acid, isophthalic acid, oxalic acid, malonic acid, succinic acid, glutaric acid, a dipic acid, pyruvic acid, butyric acid, pivalic acid, 2,2-dimethyl butyrate, 3,3-dim ethyl butyrate, 2,2-dimethyl valerate, 2,2-diethyl butyrate, 3,3-diethyl butyrate, na phthenic acid, cyclohexanedicarboxylic acid, 2-acryloyloxyethyl succinate, 2-metha cryloyloxyethyl succinate, 2-acryloyloxyethyl hexahydro phthalate, 2-methacryloylo xyethyl hexahydro phthalate, 2-acryloyloxyethyl phthalate, 2-methacryloyloxyethyl phthalate, etc. may be listed. In a particular embodiment, the carboxylic acid ha s a molecular weight of 150 to 300.

In another embodiment, dicarboxylic acid are used. As such dicarboxylic acid, oxalic acid, malonic acid, succinic acid, glutaric acid, fumaric acid, maleic acid etc. may be listed. The tertiary amine is used as a mixture or salt with acidic functional groups, and forms a buffer solution or salt with the acidic functional group of the carboxylic acid in order to prevent excessively rapid reaction with other resin components, or to suppress migration.

The amine may be a monomer, oligomer, or polymer combined with one or more compound. In particular, alkanolamines are preferable, and for example, as tertiary alkanolamines such as triethanolamine and N,N,N, N,N,N',N'-Tetrakis (2-hydroxyethyl) ethylenediamine can be listed as those favorable in forming buffer mixtures or salts with the carboxylic acidic functional group.

As aldehydes, aldoses such as glutaraldehyde, perillaldehyde, and glyceraldehyde may be listed.

As ketones, acetylacetone, β diketones such as 3,5-heptanedione, or ketoses such as erythrulose may be listed.

By having such flux components in a state of phase separation with the polymer having the polydimethylsiloxane structure, a phase that is unevenly distributed near the high polarity metal particles can easily be formed, thus being able to express its flux function even more, and being further preferable.

The amount of such flux components added is preferably 1 percent by mass or more to 5 percent by mass or less, based on the entire film.

### (Other Optional Components)

In another embodiment, the conductive adhesive composition of the present invention may further include one or more additive such as a plasticizer, an oil, a stabilizer, an antioxidant, a corrosion preventative, an inhibitor, a chelating agent, a silane coupling agent, a leveling agent, a pigment, a dye, a polymer additive, a defoaming agent, a preservative, a thickener, a rheology-adjusting agent, a moisturizing agent, a tackifier, a dispersant, and water.

### (Method for Producing Adhesive Film)

The adhesive film may be produced by ordinary methods. For example, after preparing a varnish containing a curable resin, the varnish may be applied on a cover film at a certain thickness to form a coated layer, and drying the coated layer under a certain condition, the adhesive film may be produced. The method of application is not particularly limited, and roll coating, screen coating, and gravure coating etc. may be listed. Further, as the drying condition, for example, drying may be performed at a temperature of 80 to 130oC for a time range of 1 to 5 minutes. As the cover film, polyethylene-telephthalate (PET), polyethylene or polypropylene, or a plastic film or paper that is coated with a peeling agent such as fluorine-type peeling agent and long-chain alkylacrylate-type peeling agent, may be used. By using such method to obtain a film, it becomes easier to maintain the thickness between the adherend and to handle, and is thus, preferable. In order to form a film from the adhesive composition, the curable resin preferably has a molecular weight of 1000 or more, or contains polymer components.

The thickness of the adhesive film is not particularly limited, but may preferably be 1 to 300 µm. When adhering two layers of adherends, the thickness is preferably 5 to 60 µm, and when stress-relaxation is required, the thickness is preferably 60 to 200 µm.

Further, by combining the adhesive film with a dicing tape in the form of a laminate, the adhesive film may be used favorably as an adhesive film with a dicing tape. A dicing tape is a tape that is used mainly in the process of cutting and dicing integrated circuits and packages formed on a semiconductor wafer.

Since the adhesive film is radically curable, it may be used in combination with a dicing tape that has a radiation curable adhesive layer that is irradiated beforehand, or a pressure-sensitive adhesive layer on the part of the wafer that is to be adhered.

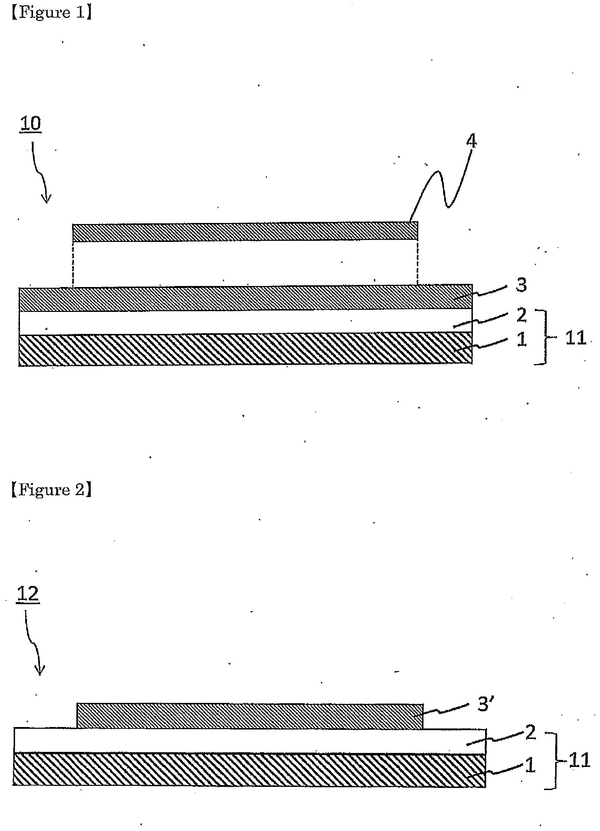

FIG 1 and FIG 2 are schematic diagrams that show the sectional views of one embodiment of the adhesive film with dicing tape of the present invention.

In FIG 1, the structure of the adhesive film with dicing tape 10, in which the adhesive film 3 is laminated on the dicing tape 11, is shown. The dicing tape 11 is composed of a pressure-sensitive adhesive layer 2 laminated on a substrate 1, and the adhesive film 3 is provided on top of the pressure-sensitive adhesive layer 2. As shown in the adhesive film with dicing tape 12 of FIG 2, the adhesive film 3' may be formed only on the work-sticking part.

The substrate 1 is the strength matrix of the adhesive film with dicing tape 10, 12 and preferably shows ultraviolet transmission property and expandability when expanded. For example, polyolefins such as polyethylene, polypropylene, polybutene, and polymethylpentene, ethylene-vinyl acetate copolymer, ionomer resin, ethylene-(meth)acrylic acid copolymer, ethylene-(meth)acrylic acid ester (random, alternating) copolymer, ethylene-butene copolymer, ethylene-hexene copolymer, polyurethane, polyesters such as polyethylene terephthalate and polyethylene naphthalate,, polycarbonate, polyimide, polyether ether ketone, polyether imide, wholly aromatic polyamide, polyphenylsulfide, aramid (paper), glass, glass cloth, fluorine resin, polyvinylchloride, polyvinylidenechloride, cellulose-type resin, silicone resin, crosslinked bodies of the aforementioned resins, metal (foil), paper etc. can be listed.

In order to enhance adhesion, retention, etc., the surface of the substrate 1 may be subjected to conventional surface treatments such as various chemical and physical treatments like chromic acid treatment, ozone exposure, flame exposure, high voltage lightening exposure, ionizing radiation treatment, coating treatment using primers (such as the later-described adhesive substance).

As the substrate 1 , the same or different materials may be arbitrarily selected and used, and several types may be blended and used as necessary. Further, different types may be layered and used.

The thickness of substrate 1 is not particularly limited, but may generally be about 50 to 200 µm.

The adhesive material to be used in the pressure-sensitive adhesive layer 2 is not particularly limited, and general pressure-sensitive adhesive such as acrylic-type adhesive and rubber-type adhesive.

As the adhesive material used to form the pressure-sensitive adhesive layer 2, radiation-curable resins may also be used. The adhesive strength of radiation-curable resins may easily be reduced by irradiation of radiation such as ultraviolet ray to increase the degree of crosslinking.

As the radiation-curable adhesive agent, those having radiation curable functional groups such as carbon-carbon double bonds that also show adhesiveness may be used without particular limitation. For example, addition-type radiation-curable adhesive agents obtained by combining radiation-curable monomer components and oligomer components to general pressure-sensitive adhesive agents such as the aforementioned acrylic-type adhesive agent and rubber-type adhesive agent may be exemplified.

As the radiation-curable monomer component to be combined, for example, urethane oligomer, urethane(meth)acrylate, trimethylol propane tri(meth)acrylate, tetramethylol methane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butanediol di(meth)acrylate etc. may be listed. Further, as the radiation-curable oligomer component, various oligomers such as urethane-type, polyether-type, polyester-type, polycarbonate-type, polybutadiene-type may be listed, and those with a molecular weight in the range of 100 to 30000 are suitable. The amount of radiation-curable monomer components and oligomer components may be determined arbitrarily according to the type of adhesive layer. In general, the amount is, for example, 5 to 500 parts by mass, or more preferably, 40 to 150 parts by mass, based on 100 parts by mass of the base polymer such as the acrylic polymer composing the adhesive layer.

Further, as the radiation-curable adhesive agent, other than the aforementioned addition-type radiation-curable adhesive agent, endogenous-type radiation-curable adhesive agents that have carbon-carbon double bonds on the polymer side chain, main chain, or end of the main chain may be listed as the base polymer. Such endogenous-type radiation-curable adhesive agents do not require the addition of oligomer components etc., or do not contain many. Thus, they are preferable since chronological migration of the oligomer components within the adhesive agent or to the adhesive film 3 does not occur.

Further, as the radiation-curable adhesive agent, for example, an addition polymerizable compound having two or more unsaturated bonds as disclosed in JP-A-S60-196956, rubber-type adhesive agents and acrylic-type adhesive agents containing a photo-polymerizable compound that has an epoxy group such as alkoxysilane and a photopolymerization initiator such as carbonyl compounds, organic sulfur compounds, peroxides, amines, onium salt-type compounds may be listed.

The thickness of the pressure-sensitive adhesive layer 2 is not particularly limited, but is preferably about 1 to 50 µm. Preferably, the thickness is 2 to 30 µm, or further preferably, 5 to 25 µm, since an adequate adhesiveness with good balance between the support property of the chip and the detachability at pickup can be obtained.

FIG 1 shows a clear example of the structure and method for producing a semiconductor device using such an adhesive film with dicing tape.

More specifically, on the semiconductor wafer sticking part of the adhesive film 3 of the adhesive film with dicing film 10, a semiconductor wafer 4 is pressure bonded, and fixed by adhesion holding (adhesion process). This process is performed by a pressurizing means such as a pressurizing roll.

### EXAMPLE

Hereinafter, the present invention will be described more specifically with reference to Examples. However, the present invention is not limited in anyway by these Examples.

### <Adhesive Film>

### (Example 1)

Copper particles coated with silver (a), Condensation polymerization type silanol-terminated polydimethylsiloxane (DMS-S45, product of Gelest, Inc.) (b), methyltriacetoxysilane (c) as a curing agent, and silicone resin (SQ-299, product of Gelest, Inc.) (d) were charged in a vessel at a ratio of (a) : (b) : (c) : (d) = 60 : 25 : 3 : 12, after which a sufficient amount of toluene was added and the mixture was kneaded using a rotating and revolving mixer to thereby obtain a varnish. This varnish was coated on a cover tape consisting of fluorine-treated PET film with a thickness of 50 µm, dried to form a film-formed adhesive composition with a thickness of 50 µm, and bonded together with a dicing tape to prepare an adhesive film with dicing tape.

### (Example 2)

A metal particle mixture consisting of 78 weight% of copper particle and 22 weight% of tin particle (a), a vinyl-terminal modified polydimethylsiloxane (DMS-V52, product of Gelest, Inc.) (b), hydrogen silane modified polydimethylsiloxane (HMS-501, product of Gelest, Inc.) (c) as a crosslinking agent, 2,3-dimethyl-2,3-diphenyl butane (d) as a catalyst, silicone resin (SQ-299, product of Gelest, Inc.), tetraethyleneglycol (f) as a flux, and a silane coupling agent (KBM1003, product of Shin-Etsu Silicone) (g) as an additive, were charged in a vessel at a ratio of (a) : (b) : (c) : (d) : (e) : (f) : (g) = 60 : 22 : 2 : 1 : 9 : 5 : 1, after which a sufficient amount of toluene was added as a solvent and the mixture was kneaded using a rotating and revolving mixer. Subsequently, a sufficient amount of hexane was added, and a varnish was prepared by high-speed stirring using a homogenizing disper. This varnish was coated on a cover tape consisting of fluorine-treated PET film with a thickness of 50 µm, dried to form a film-formed adhesive composition with a thickness of 50 µm, and bonded together with a dicing tape to prepare an adhesive film with dicing tape.

### (Example 3)

Other than using a metal particle mixture consisting of 60 weight% of copper particle, 34 weight% of tin particle, and 6 weight% of zinc particle as (a), an adhesive film with dicing tape was prepared by the same method as that described in Example 2.

### (Example 4)

Other than using a metal particle mixture consisting of 60 weight% of copper particle, 28 weight% of tin particle, and 12 weight% of bismuth particle as (a), an adhesive film with dicing tape was prepared by the same method as that described in Example 2.

### (Example 5)

Other than adding the materials at a ratio of (a) : (b) : (c) : (d) : (e) : (f) : (g) = 55 : 23 : 2 : 1 : 12 : 6 : 1, an adhesive film with dicing tape was prepared by the same method as that described in Example 4.

### (Example 6)

Other than adding the materials at a ratio of (a) : (b) : (c) : (d) : (e) : (f) : (g) = 50 : 25 : 3 : 1 : 14 : 6 : 1, an adhesive film with dicing tape was prepared by the same method as that described in Example 4.

### (Example 7)

Other than using an organic peroxide (diisopropylbenzene hydroperoxide) as (d), an adhesive film with dicing tape was prepared by the same method as that described in Example 4.

### (Example 8)

Other than using a 0.1 M silicone oil solution of a platinum catalyst (Platinum(0)1,3-divinyl-1,1,3,3-tetramethyl) disiloxane complex) as (d), gum rosin as (f), and styrene ethylene butylene styrene elastomer as (g), and adding the materials at a ratio of (a) : (b) : (c) : (d) : (e) : (f) : (g) = 60 : 5 : 1 : 1 : 5 : 18 : 10, an adhesive film with dicing tape was prepared by the same method as that described in Example 4.

### (Example 9)

A metal particle mixture consisting of 60 weight% of copper particles, 28 weight% of tin particles, and 12 weight% of bismuth particles (a), a carboxyl modified polydimethylsiloxane (X22-162C, product of Shin-Etsu Silicone) (b), silicone resin (SQ-299, product of Gelest, Inc.) (c), vinylmethoxysiloxane oligomer (VMM-010, product of Gelest, Inc.) (d) as a crosslinking agent, and an organic peroxide (diisopropylbenzene hydroperoxide) (e) as a catalyst, were charged in a vessel at a ratio in volume% of (a) : (b) : (c) : (d) : (e) = 60 : 25 : 11 : 3 : 1, after which a sufficient amount of toluene was added as a solvent and the mixture was kneaded using a rotating and revolving mixer to prepare a varnish. This varnish was coated on a cover tape consisting of fluorine-treated PET film with a thickness of 50 µm, dried to form a film-formed adhesive composition with a thickness of 50 µm, and bonded together with a dicing tape to prepare an adhesive film with dicing tape.

### (Example 10)

A metal particle mixture consisting of 60 weight% of copper particles, 28 weight% of tin particles, and 12 weight% of bismuth particles (a), a 1 : 1 mixture of a vinyl-terminal modified polydimethylsiloxane (DMS-V52, product of Gelest, Inc.) and a carboxyl modified polydimethylsiloxane (X22-162C, product of Shin-Etsu Silicone) (b), a hydrogen silane modified polydimethylsiloxane (HMS-501, product of Gelest, Inc.) (c) as a crosslinking agent, 2,3-dimethyl-2,3-diphenyl butane (d), silicone resin (SQ-299, product of Gelest, Inc.) (e), and a silane coupling agent (KBM1003, product of Shin-Etsu Silicone) (f) as an additive, were charged in a vessel at a ratio in volume% of (a) : (b) : (c) : (d) : (e) : (f) = 60 : 27 : 3 : 1 : 8: 1, after which a sufficient amount of toluene was added as a solvent and the mixture was kneaded using a rotating and revolving mixer to prepare a varnish. This varnish was coated on a cover tape consisting of fluorine-treated PET film with a thickness of 50 µm, dried to form a film-formed adhesive composition with a thickness of 50 µm, and bonded together with a dicing tape to prepare an adhesive film with dicing tape.

### (Example 11)

Other than using a 1 : 1 mixture of a vinyl-terminal modified polydimethylsiloxane (DMS-V52, product of Gelest, Inc.) and a carbinol modified polydimethylsiloxane (KF6000, product of Shin-Etsu Silicone) as (b), an adhesive film with dicing tape was prepared by the same method as that described in Example 10.

### (Example 12)

A metal particle mixture consisting of 60 weight% of copper particles, 28 weight% of tin particles, and 12 weight% of bismuth particles (a), a 1 : 1 mixture of a vinyl-terminal modified polydimethylsiloxane (DMS-V52, product of Gelest, Inc.) and a carboxyl modified polydimethylsiloxane (X22-162C, product of Shin-Etsu Silicone) (b), a hydrogen silane modified polydimethylsiloxane (HMS-501, product of Gelest, Inc.) (c) as a crosslinking agent, 2,3-dimethyl-2,3-diphenyl butane (d) as a catalyst, and a 0.1 M silicone oil solution of a platinum catalyst (Platinum(0)1,3-divinyl-1,1,3,3-tetramethyl disiloxane complex) (e), a silicone resin (SQ-299, product of Gelest, Inc.) (f), N, N, N', N'- tetrakis(2-hydroxyethyl) ethylenediamine (g) as a flux, and a silane coupling agent (KBM1003, product of Shin-Etsu Silicone) (h) as an additive, were charged in a vessel at a ratio in volume% of (a) : (b) : (c) : (d) : (e) : (f) : (g) : (h) = 60 : 22 : 3 : 1 : 1: 6 : 6 : 1, after which a sufficient amount of toluene was added as a solvent and the mixture was kneaded using a rotating and revolving mixer. Subsequently, a sufficient amount of hexane was added, and a varnish was prepared by high-speed stirring using a homogenizing disper. This varnish was coated on a cover tape consisting of fluorine-treated PET film with a thickness of 50 µm, dried to form a film-formed adhesive composition with a thickness of 50 µm, and bonded together with a dicing tape to prepare an adhesive film with dicing tape.

### (Comparative Example 1)

A metal particle mixture consisting of 70 weight% of tin particles and 30 weight% of bismuth particles (a), a bisphenol A-type epoxy (RE310, product of Nippon Kayaku Co., Ltd.) (b) as an epoxy resin, a phenoxy resin (YP50S, product of Nippon Steel and Sumikin Chemical Co., Ltd.) (c), dicyandiamide (d) as a curing agent, 1-phenylimidazole (e) as a catalyst, and tetraethyleneglycol (f) as a flux, were charged in a vessel at a ratio in volume% of (a) : (b) : (c) : (d) : (e) : (f) = 55 : 7 : 25 : 2 : 1 : 10, after which a sufficient amount of cyclohexanone was added as a solvent and the mixture was kneaded using a rotating and revolving mixer to prepare a varnish. This varnish was coated on a cover tape consisting of fluorine-treated PET film with a thickness of 50 µm, dried to form a film-formed adhesive composition with a thickness of 50 µm, and bonded together with a dicing tape to prepare an adhesive film with dicing tape.

### (Comparative Example 2)

Other than using a metal particle mixture consisting of 60 weight% of copper particle, 28 weight% of tin particle, and 12 weight% of bismuth particle as (a), an adhesive film with dicing tape was prepared by the same method as that described in Comparative Example 1.

### (Comparative Example 3)

A metal particle mixture consisting of 60 weight% of copper particles, 28 weight% of tin particles, and 12 weight% of bismuth particles (a), a silicone oil (KF-986, product of Shin-Etsu Silicone) (b), and tetraethyleneglycol (c) as a flux, were charged in a vessel at a ratio in volume% of (a) : (b) : (c) = 60 : 30 : 10, after which a sufficient amount of toluene was added as a solvent and the mixture was kneaded using a rotating and revolving mixer. Subsequently, a sufficient amount of hexane was added, and a varnish was prepared by high-speed stirring using a homogenizing disper. This varnish was coated on a cover tape consisting of fluorine-treated PET film with a thickness of 50 µm, dried to form high viscosity paste.

### (Comparative Example 4)

Other than adding the materials at a ratio of (a) : (b) : (c) : (d) : (e) : (f) : (g) = 70 : 4 : 1 : 1 : 10 : 13 : 1, the same method was used as that described in Example 4 to obtain a varnish. This varnish was coated on a cover tape consisting of fluorine-treated PET film with a thickness of 50 µm, dried to form an extremely brittle thin layered solid laminated on the PET film.

### (Comparative Example 5)

Other than using copper particles as (a), an adhesive film with dicing tape was prepared by the same method as that described in Example 2.

Note that evaluation methods for each performance were as follows.

### <State of Phase>

The cross-section of the adhesive compositions of Examples 1 to 12 and Comparative Examples 1 to 5 were observed by an optical microscope, and those in which the resin composition parts were of a uniform phase were determined as being "compatible," while others were determined to be "separated."

### <Film Formation>

The film-formed adhesive compositions of Examples 1 to 12 and Comparative Examples 1 to 5 were cut in to strips of 1 cm x 5 cm. One end was picked using tweezers to slowly peel, and those that could be peeled off from the cover tape in a film form were rated A, while those that could not be peeled due to being in fluid form or brittle solid form were rated B.

### <Sinterability>

Among the adhesive composition of Examples 1 to 12 and Comparative Examples 1 to 5, those that were rated A for film formation were adhered to a silicon wafer, which was subjected to gold-plating treatment on the surface. The cover film was removed, after which it was sintered under nitrogen atmosphere at 200°C or 250°C for 2 hours. The surface of the sintered adhesive was polished, after which the polished surface was observed by electron microscope and fluorescent X-ray analysis. Those for which formation of intermetallic compounds were seen were rated A, while those for which formation of intermetallic compounds were not seen were rated B.

### <Volume Resistivity>

Among the adhesive composition of Examples 1 to 12 and Comparative Examples 1 to 5, those that were rated A for film formation were adhered to glass. After removing the cover film, the samples were subjected to sintering under nitrogen atmosphere at 250°C for 2 hours. The surface of the sintered adhesive was polished, after which the volume resistivity of the polished surface was measured by the four-point probe method according to JIS-K7194.

### <Curving>

Among the adhesive composition of Examples 1 to 12 and Comparative Examples 1 to 5, the cover films were removed from those that were rated A for film formation. Then, they were adhered to a silicon wafer, which was subjected to gold-plating treatment on the surface, with a thickness of 350 µm, and diced to a size of 5 mm x 5 mm using a dicing saw to obtain diced semiconductor chips with adhesive film on the dicing tape. These diced semiconductors with adhesive film were peeled from the dicing tape using a pickup die bonder, and 16 semiconductor chips were bonded at equal intervals on an iron nickel42 alloy lead frame with a surface that has been subjected to silver-plating treatment that is 100 mm x 200 mm x 160 µm in size. Then, the samples were subjected to sintering under nitrogen atmosphere at 250°C for 2 hours. When each lead frame with chip were set on an even surface, those that showed a gap of 2 mm or more due to the curving of the lead frame were rated B, while those that showed a gap of less than 2 mm were rated A.

### <Adhesive Strength>

As with the curving evaluation test, samples were prepared by bonding semiconductor chips to a lead frame, and by subjecting those to sintering under nitrogen atmosphere at 200°C or 250°C for 2 hours. The shear bond strength between the chip and lead frame was measured for each sample using a shear bond strength tester (Arctec, Inc. Series 4000).

Further, details of the components and dicing tape used were as follows.

### <Base Substrate>

Commercial resin beads consisting of low-density polyethylene (Novatec LL, product of Japan Polyethylene Corporation) was melted at 140 °C, and molded in to a long film with a thickness of 100 µm using an extruder. <Adhesive Composition> In 400 g of toluene solvent, 240 g of n-octylacrylate, 13 g of 2-hydroxyethylacrylate, 6 g of methacrylic acid, and a mixed solution of benzoyl peroxide as a polymerization initiator were slowly added by adjusting the dripping amount, controlling the reaction temperature and reaction time, to obtain a solution of acrylic resin with a functional group. Subsequently, 6 parts by weight of Coronate L (product of Japan Polyurethane Industry Co., Ltd.) was added as a polyisocyanate, 300 parts by weight of ethyl acetate was added as a solvent, and subjected to mixing, to thereby obtain adhesive composition 1.

### <Dicing Tape>

The above-described adhesive composition was coated on a support substrate, so that the thickness after the adhesive composition is dried becomes 5 µm, and dried at 110 °C for 3 minutes, to thereby obtain a dicing tape.

The evaluation results are shown in Table 1 (Examples) and Table 2 (Comparative Examples).

**[Table 1]**

| | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|
| Composition | Metal | Component 1 | Cu | ← | ← | ← | ← | ← | ← | ← | ← | ← | ← | ← |
| | | Component 2 | Ag | Sn | ← | ← | ← | ← | ← | ← | ← | ← | ← | ← |
| | | Component 3 | - | - | Zn | Bi | ← | ← | ← | ← | ← | ← | ← | ← |
| | | vol% | 60 | 60 | 60 | 60 | 55 | 50 | 60 | 60 | 60 | 60 | 60 | 60 |
| | Binder | Component | Condensation-type PDMS | Vinyl modified PDMS | ← | ← | ← | ← | ← | ← | COOH modified PDMS | Vinyl modified PDMS + COOHmodified PDMS | Vinyl modified PDMS + ROH modified PDMS | Vinyl modified PDMS + COOH modified PDMS |
| | | vol% | 25 | 22 | ← | ← | 23 | 25 | 22 | 5 | 25 | 27 | 27 | 22 |
| | Curing Agent | Component | MTAS | DMDPB | ← | ← | ← | ← | Organic Peroxide | Pt Catalyst | - | DMDPB | ← | Pt Catalyst + DMDPB |
| | | 1hr half-life temperature | 234°C | 234°C | ← | ← | ← | ← | 183°C | - | - | 234°C | ← | ← |
| | Flux | | None | Tetraetyleneglycol | ← | ← | ← | ← | ← | Rosin | - | - | - | Hydroxylamine |
| | State of Phase | | - | Separated | Separated | Separated | Separated | Separated | Separated | Separated | Compatible | Compatible | Compatible | Separated |
| Evaluation Result | Film Formation | | A | A | A | A | A | A | A | A | A | A | A | A |
| | Sintering | 200°C | B | B | A | A | A | A | A | A | A | A | A | A |
| | | 150°C | B | A | A | A | A | A | A | A | A | A | A | A |
| | Volume Resistivity *µ* Ω·cm | | 120 | 37 | 46 | 39 | 55 | 98 | 45 | 30 | 83 | 60 | 49 | 33 |
| | Curving | | A | A | A | A | A | A | A | A | A | A | A | A |
| | Adhesive Strength Mpa | Room Temperatur | 17 | 23 | 40 | 26 | 30 | 29 | 24 | 22 | 20 | 37 | 33 | 28 |
| | | 200°C | 3.2 | 5.8 | 12 | 6 | 7.2 | 7.6 | 5.5 | 2.3 | 4.6 | 9 | 8.7 | 6.5 |
| | | 250°C | 2.1 | 5 | 12 | 4.0 | 5.1 | 4.8 | 4 | 0.6 | 3.2 | 7.2 | 7 | 5.5 |

**[Table 2]**

| | | | Comparative Example 1 | Comparative Example 2 | Comparative Example 3 | Comparative Example 4 | Comparative Example 5 |
|---|---|---|---|---|---|---|---|
| Composition | Metal | Component 1 | Sn | Cu | ← | ← | Cu |
| | | Component 2 | Bi | Sn | ← | ← | - |
| | | Component 3 | - | Bi | ← | Bi | - |
| | | vol% | 55 | 55 | 60 | 70 | 60 |
| | Binder | Component | Epoxy + Phenoxy | ← | Silicone Oil | Vinyl modified PDMS | Vinyl modified PDMS |
| | | vol% | 32 | 32 | 30 | 4 | 22 |
| | Curing Agent | Component | DICY + Imidazole | ← | - | DMDPB | ← |
| | | 1hr Half-life Temperature | - | - | - | 234°C | ← |
| | Flux | | Tetraethyleneglycol | ← | ← | ← | |
| | State of Phase | | - | - | - | Separated | Separated |
| Evaluation Result | Film Formation | | A | A | B | B | A |
| | Sintering | 200°C | B | A | - | - | B |
| | | 250°C | B | A | - | - | B |
| | Volume Resistivity *µ* Ω·cm | | 220 | 52 | - | - | 270 |
| | Curving | | B | B | - | - | A |
| | Adhesive Strength Mpa | Room Temperature | 58 | 53 | - | - | 8.7 |
| | | 200°C | 0.3 | 4.6 | - | - | 1.7 |
| | | 250°C | 0 | 1.7 | - | - | 0.9 |

As shown in Examples 1 to 12, the conductive adhesive film that contains two or more types of metal particles including at least Cu and a polymer that has a polydimethylsiloxane structure proved to be a highly reliable adhesive film, maintaining high adhesive strength even in high temperature and showing no curvatures. In Example 1, even though intermetallic compounds were not formed, it showed no problem unless it is to be used in large current high frequency IGBT etc.

In Comparative Examples 1 to 3, because of the lack of polymer with a polydimethylsiloxane structure, crucial problems were found in basic film-forming aptitude such as film formability and curving.

Comparative Example 4 is a very brittle solid that is in the form of a powder aggregate, and shows no film formability (lacks all preconditions as a film).

Comparative Example 5 does not contain metals other than copper, and thus, its volume resistivity was extremely large, causing problems in its conductivity. Also it can be seen that its adhesive strength was inferior.

### DESCRIPTION OF NOTATIONS

- 1 .: substrate
- 2: pressure-sensitive adhesive layer
- 3: adhesive film (thermosetting-type adhesive film)
- 4: semiconductor wafer
- 10, 12: adhesive film with dicing tape
- 11: dicing film

## Claims

1. A conductive lead-free adhesive film, which comprises two or more types of metal particles including at least Cu, and a polymer that has a polydimethylsiloxane structure, wherein at least part of the polymer that has a polydimethylsiloxane structure contains -COOH, -CRₓ(OH)_{y}, or -NR₂ as a functional group (where R is selected from H, alkyl, or aryl group, and x+y=3), and wherein the metal particles are capable of forming an intermetallic compound.

2. The conductive adhesive film according to Claim 1, wherein at least part of the metal particles contain a component with a melting point of 250°C or lower.

3. The conductive adhesive film according to any one of Claims 1 or 2, which contains at least one type of flux component selected from alcohol, ketone, carboxylic acid, or amine, wherein the flux component is in a state of phase separation with the polymer that has a polydimethylsiloxane structure.

4. The conductive adhesive film according to any one of Claims 1 to 3, wherein the metal particles amount to 55 volume% or more of the entire film and the polymer that has a polydimethylsiloxane structure amounts to 5 volume% or more of the entire film.

5. The conductive adhesive film according to any one of Claims 1 to 4, wherein at least part of the polymer that has a polydimethylsiloxane structure contains a double bond.

6. The conductive adhesive film according to any one of Claims 1 to 5, which comprises a radical generator with a one-hour half-life temperature of 200°C or higher.

7. A dicing die bonding film, which comprises the conductive adhesive film of any one of Claims 1 to 6 and a dicing tape laminated thereon.

8. A method for processing semiconductor wafer using the conductive adhesive film of any one of Claims 1 to 6.

9. A method for processing semiconductor wafer using the dicing die bonding film of Claim 7.

## Patentansprüche

1. Ein leitfähiger bleifreier Klebstofffilm, der zwei oder mehr Arten von Metallpartikeln, einschließlich wenigstens Cu, und ein Polymer, das eine Polydimethylsiloxanstruktur aufweist, umfasst, wobei wenigstens ein Teil des Polymers, das eine Polydimethylsiloxanstruktur aufweist, -COOH, -CRₓ(OH)_{y} oder -NR₂ als eine funktionelle Gruppe enthält (wobei R aus H, einer Alkyl- oder Arylgruppe ausgewählt ist, und x+y=3), und wobei die Metallpartikel in der Lage sind, eine intermetallische Verbindung auszubilden.

2. Der leitfähige Klebstofffilm nach Anspruch 1, wobei wenigstens ein Teil der Metallpartikel eine Komponente mit einem Schmelzpunkt von 250 °C oder niedriger enthält.

3. Der leitfähige Klebstofffilm nach einem der Ansprüche 1 oder 2, der wenigstens eine Art von Flussmittelkomponente enthält, die aus Alkohol, Keton, Carbonsäure oder Amin ausgewählt ist, wobei sich die Flussmittelkomponente in einem Zustand der Phasentrennung mit dem Polymer, das eine Polydimethylsiloxanstruktur aufweist, befindet.

4. Der leitfähige Klebstofffilm nach einem der Ansprüche 1 bis 3, wobei die Metallpartikel wenigstens 55 Vol.-% des gesamten Films ausmachen und das Polymer, das eine Polydimethylsiloxanstruktur aufweist, wenigstens 5 Vol.-% des gesamten Films ausmacht.

5. Der leitfähige Klebstofffilm nach einem der Ansprüche 1 bis 4, wobei wenigstens ein Teil des Polymers, das eine Polydimethylsiloxanstruktur aufweist, eine Doppelbindung enthält.

6. Der leitfähige Klebstofffilm nach einem der Ansprüche 1 bis 5, der einen Radikalgenerator mit einer einstündigen Halbwertszeittemperatur von 200 °C oder höher umfasst.

7. Ein Dicing-Die-Bonding-Film, der den leitenden Klebstofffilm nach einem der Ansprüche 1 bis 6 und ein darauf laminiertes Dicing-Band umfasst.

8. Ein Verfahren zum Verarbeiten eines Halbleiterwafers unter Verwendung des leitfähigen Klebstofffilms nach einem der Ansprüche 1 bis 6.

9. Ein Verfahren zum Verarbeiten des Halbleiterwafers unter Verwendung des Dicing-Die-Bonding-Films nach Anspruch 7.

## Revendications

1. Film adhésif conducteur sans plomb, comprenant au moins deux types de particules métalliques dont au moins du Cu, et un polymère présentant une structure polydiméthylsiloxane, dans lequel au moins une partie du polymère présentant une structure polydiméthylsiloxane contient du -COOH, -CRₓ(OH)_{y} ou -NR₂ en tant que groupement fonctionnel (où R est choisi parmi le groupe H, alkyle ou aryle, et x + y = 3), et dans lequel les particules métalliques sont capables de former un composé intermétallique.

2. Film adhésif conducteur selon la revendication 1, dans lequel au moins une partie des particules métalliques contiennent un composant ayant un point de fusion inférieur ou égal à 250 °C.

3. Film adhésif conducteur selon l'une quelconque des revendications 1 à 2, contenant au moins un type de composant de flux choisi parmi l'alcool, la cétone, l'acide carboxylique ou l'amine, dans lequel le composant de flux est dans un état de séparation de phases avec le polymère ayant une structure polydiméthylsiloxane.

4. Film adhésif conducteur selon l'une quelconque des revendications 1 à 3, dans lequel les particules métalliques représentent 55 % en volume ou plus du film entier et le polymère ayant une structure polydiméthylsiloxane représente 5 % en volume ou plus du film entier.

5. Film adhésif conducteur selon l'une quelconque des revendications 1 à 4, dans lequel au moins une partie du polymère ayant une structure polydiméthylsiloxane contient une double liaison.

6. Film adhésif conducteur selon l'une quelconque des revendications 1 à 5, comprenant un générateur de radical avec une température de demi-vie d'une heure de 200 °C ou plus.

7. Film de découpe/fixage de puces, comprenant le film adhésif conducteur selon l'une quelconque des revendications 1 à 6 et un ruban de découpe stratifié sur celui-ci.

8. Procédé de traitement d'une tranche de semi-conducteur à l'aide du film adhésif conducteur selon l'une quelconque des revendications 1 à 6.

9. Procédé de traitement d'une tranche de semi-conducteur à l'aide du film de découpe/fixage de puces selon la revendication 7.
